# EUROPEAN PATENT SPECIFICATION

(11) **EP 3 234 215 B1**
(45) Date of publication and mention of the grant of the patent: **07.08.2019**
(21) Application number: 15813515.2
(22) Date of filing: 14.12.2015
(51) Int. Cl.: C23C 16/40, C23C 16/515, C23C 16/54, H01J 37/32, H01L 51/00, C08J 7/00

(54) **METHOD FOR PREPARING TRANSPARENT SHEET MATERIALS**
VERFAHREN ZUR HERSTELLUNG EINES TRANSPARENTEN BOGENMATERIALS
PROCÉDÉ DE PRÉPARATION DE MATÉRIAUX EN FEUILLES TRANSPARENTS

(30) Priority: 19.12.2014 GB 201422800
(43) Date of publication of application: 25.10.2017
(73) Proprietor: Fujifilm Manufacturing Europe BV, 5047 TK Tilburg (NL)
(72) Inventor: BOUWSTRA, Jan, 5047 TK Tilburg (NL); DE VRIES, Hindrik, 5047 TK Tilburg (NL); STAROSTINE, Serguei, 5047 TK Tilburg (NL)
(74) Representative: Revell, Christopher
(86) International application number: PCT/GB2015/053948
(87) International publication number: WO 2016/097704

(56) References cited:
- WO-A1-2008/045226
- US-A1- 2013 076 191
- EETERS P ET AL: "Uniform glow-like atmospheric DBD for surface treatment and deposition", ANNUAL TECHNICAL CONFERENCE PROCEEDINGS SOCIETY OF VACUUM COATERS, ALBUQUERQUE, NM, US, no. 48, 1 January 2005 (2005-01-01), pages 224-228, XP009094763,

## Description

The present invention relates to a method for preparing transparent sheet materials, to transparent sheet materials and to a method for reducing or avoiding heat-induced haze in such materials.

Transparent materials are used widely in many applications, including electronic and optical devices. Many of the transparent materials are organic polymers, e.g. polyethylene terephthalate (PET) films, polyethylene naphthalate (PEN) and the like. During their preparation or use, such materials are often exposed to elevated temperatures which reduce their transparency through haze formation, possibly as a result of monomers migrating from within the material to the surface where they form a deposit.

One option for reducing heat-induced haze formation in PET is to use a PET having a very low monomer content. However PET having a very low monomer content is expensive.

WO2009104957 ('957) addresses the technical problem of providing substrates having excellent barrier properties, such as a low water vapour transmission rate, low oxygen transmission rate and more particularly excellent roughness properties. '957 describes the use of plasma enhanced chemical vapour deposition (PECVD) to deposit a thick layer of inorganic barrier material (50 nm thickness or more) onto slowly moving substrate using a typical energy of about 240 J/cm².

WO2010092383 ('383) addresses the technical problem of providing substrates having a low water vapour transmission rate. The solution provided in '383 was to apply two inorganic layers to the same side of a substrate, the first being a buffer layer and the second being a barrier layer. The buffer layer was applied to the substrate using an energy of 30 J/cm² or less and the barrier layer was applied to the buffer layer using an energy of 40 J/cm² or more. In Examples A1, A6 and A11 buffer layers of thickness 7nm were deposited onto just one side of a PET substrate using an energy of 1.2 J/cm². In Examples B5, B6 and B7 a barrier layer of thickness 40nm was then deposited on top of the aforementioned buffer layer using an energy of 80 J/cm². Thus in '383 the layers were applied to the same side of the PET substrate and the technical problem addressed was to provide substrates having a low water vapour transmission rate.

PECVD is a known method for depositing inorganic layers onto substrates. PECVD is generally accomplished as follows: a gas mixture comprising a precursor is introduced into a treatment space that contains a substrate. The gas mixture in the treatment space is then energized into a plasma by applying electrical energy to the gas mixture. The excited gas mixture then deposits a layer of inorganic material on a surface of the substrate. Typically the volatile by-products produced during the excitation are pumped from the treatment space through an exhaust system.

US2008132080 ('080) addresses the problem of unwanted powder being deposited on the surface of films during the PECVD method, thereby creating a sheet material which suffers from the problem of haze from the outset. This is different from the present problem where the sheet material often has good transparency after PECVD has been completed, but then and haze appears later, typically in use, when the sheet material is exposed to heat. The solution proposed in '080 was to ensure that the power applied to form the plasma in the PECVD method was maintained, at least at a minimal level, until reactive silicon-containing compounds present above the surface of the substrate had been evacuated from the treatment space or had been consumed.

None of '957, '383 and '080 address the technical problem of reducing or avoiding heat-induced haze formation in transparent materials. In Annual Technical Conference Proceedings, Society of Vacuum Coaters, No. 48 (2005), pages 224-228 a further PECVD method of depositing a silicon-containing layer on a PET substrate is disclosed.

The present method provides a solution to the different technical problem of heat-induced haze formation in transparent sheet materials, especially flexible transparent sheet materials, which is of particular value for electronic and optical devices.

According to a first aspect of the present invention there is provided a method for preparing a transparent sheet material comprising an organic, polymeric substrate and an inorganic layer on each side of the substrate, the method comprising the steps of:
a) providing an apparatus for generating a glow discharge plasma, said apparatus comprising at least two opposing electrodes, a power supply for the electrodes and a treatment space between the electrodes;
b) providing the treatment space with a gas mixture at about atmospheric pressure, the gas mixture comprising a reactive gas and a precursor; and
c) moving a transparent substrate through the treatment space comprising the gas mixture at an average speed of at least 1 m/min while applying an electrical potential across the electrodes, thereby generating a glow discharge plasma in the treatment space and depositing an inorganic layer on one or both sides of the substrate;
wherein:
(i) the organic, polymeric substrate is polyethylene terephthalate or polyethylene naphthalate;
(ii) the electrodes apply a discharge energy to the substrate of less than 25 J/cm2;
(iii) the overall thickness of the inorganic layer on each side of the substrate is less than 5 nm and
(iv) the inorganic layer on each side of the substrate comprises silicon.

### BRIEF DESCRIPTION OF THE DRAWINGS

For comparative purposes,
Fig.1 shows a cross-sectional view of the sheet materials known from '383.
Fig.2 shows a cross-sectional view of a sheet material arising from the present method.
Fig. 3 is a schematic illustration of the apparatus and method used in the Examples of the present invention.
Fig. 4 is a schematic illustration of an alternative apparatus for performing the method of the present invention.
Fig. 5 illustrates the use of dielectric layers and the gap distance between two opposing electrodes

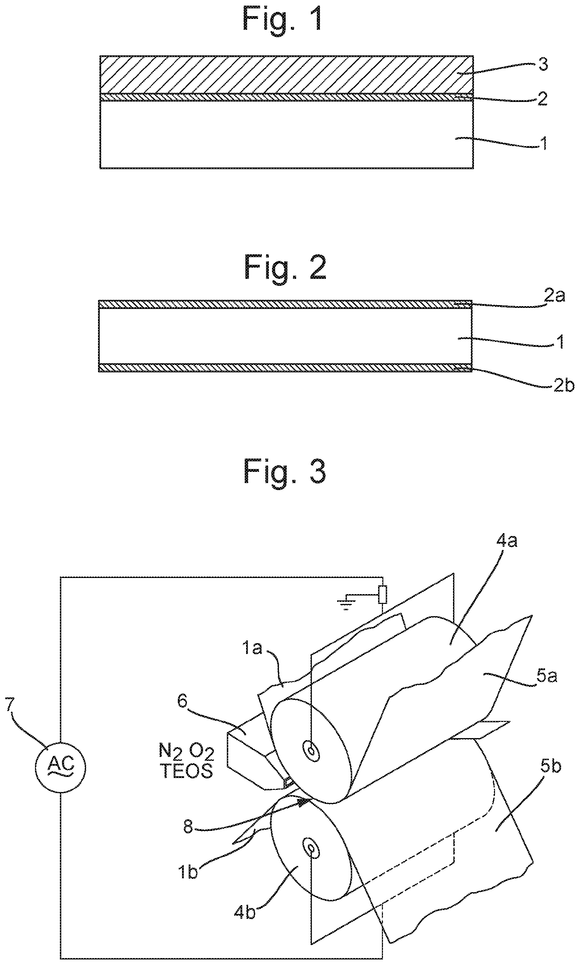

Starting with Fig. 3 first, Fig. 3 is a schematic illustration of the apparatus and method used in Examples of the present invention. The apparatus for generating a glow discharge plasma comprises two opposing electrodes 4a and 4b, a power supply 7 for the electrodes and a treatment space 8 between electrodes 4a and 4b. A gas injector 6 provides a gas mixture (precursor (e.g. TEOS), oxygen and nitrogen) to the treatment space 8 at about atmospheric pressure. Two sheets of substrate 1a and 1b in the form of polymeric webs are moved from left to right through the treatment space 8 comprising the gas mixture at a speed of at least 1 m/min while the power source 7 applies an electrical potential across electrodes 4a and 4b, thereby generating a glow discharge plasma (not shown) in the treatment space 8, thereby depositing an inorganic layer on one side of each of the substrates 1a and 1b. The speed and power source 7 are used to control the discharge energy applied to the substrates 1a, 1b to less than 25 J/cm². The resultant intermediate sheet materials 5a and 5b exiting the treatment space have an inorganic layer on only one side. Therefore the intermediate sheet materials 5a, 5b carrying an inorganic layer on only one side may be reversed and then passed through a second apparatus of the type shown in Fig. 3 in order to similarly apply an inorganic layer to the other side and thereby provide a transparent sheet material according to the present invention.

Although Fig. 3 shows only one treatment space, the method requires at least two inorganic layers to be deposited on the substrates 1a, 1b, one on each side. The two inorganic layers may be deposited on the substrates 1a, 1b in the same treatment space or in different treatment spaces, e.g. in series. In the plasma treatment apparatus of Fig. 3, the electrodes 4a, 4b are connected to an AC power source 7 and inter alia supplies electrical power to the electrodes 4a, 4b. The plasma discharge in the treatment space 8 may be controlled by special circuitry to sustain a very uniform plasma glow discharge at near atmospheric pressure, even up to a 100% duty cycle.

Fig.1 shows a cross-sectional view of the sheet materials known from '383 which comprise a polymeric substrate 1, a thin buffer layer 2 and a thick barrier layer 3. In '383 the buffer layer was applied to the substrate using an energy of 30 J/cm² or less and the barrier layer was applied to the buffer layer using an energy of 40 J/cm² or higher.

Fig. 2 illustrates a transparent sheet material made by the present method comprising an organic, polymeric substrate 1 and thin inorganic layers 2a and 2b on each side of the substrate 1.

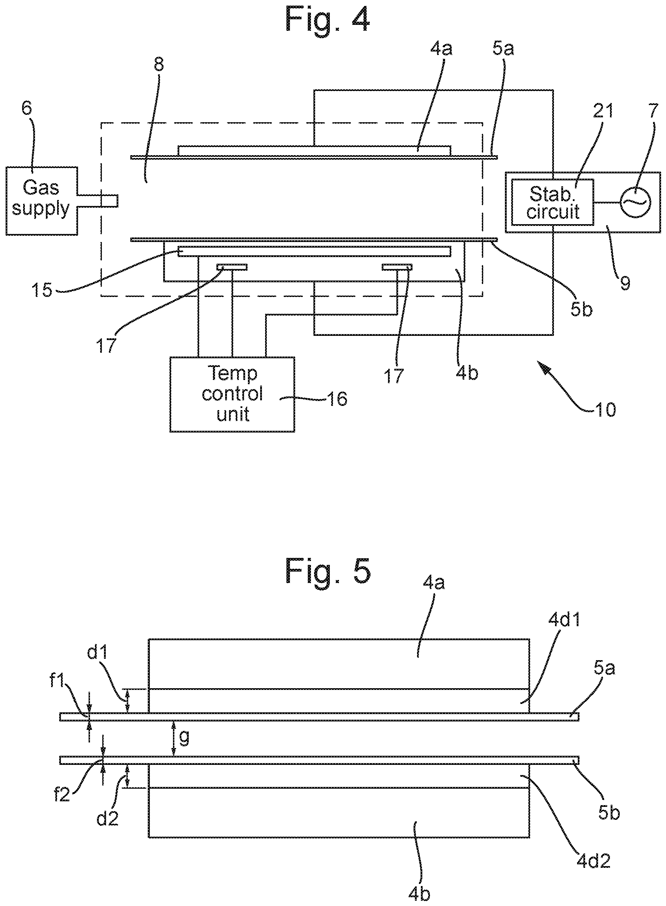

An alternative apparatus for performing the method of the present invention shown schematically in Fig. 4.

The gas supply device 6 (e.g. gas injector) optionally comprises storage, supply and mixing components (e.g. a buffer chamber).

In step b) the gas mixture is provided at about atmospheric pressure, for example at a pressure from 50 to 150% of atmospheric pressure, preferably 75 to 125% of and especially 90 to 100% of atmospheric pressure.

Electrodes 4a, 4b may have the same configuration, e.g. with both being flat (as shown in Fig. 4) or both being of circular cross-section, e.g. roll-electrodes (as shown in Fig. 3). Alternatively electrodes 4a, 4b may have different configurations. Thus one may use an electrode of circular cross-section 4a and a flat electrode 4b opposing each other. Preferred roll-electrodes have a cylinder shape and are rotatable, e.g. being mounted to allow rotation in operation using, for example, a mounting shaft or bearings. Suitable roll-electrodes 4a, 4b may be freely rotatable and optionally the apparatus further comprises a drive means for rotating the roll-electrode(s) e.g. using known controller and drive units.

Electrodes 4a, 4b optionally comprise a dielectric barrier layer and/or the substrate 1 can act as a dielectric barrier layer. Preferably the opposing electrodes are rotatable, roll-electrodes for practical and economic reasons. The inorganic layer deposition time can be controlled by selecting an appropriate movement speed in step c).

Optionally two substrates may be moved simultaneously in step c), e.g. step c) optionally comprises moving two transparent substrates through the treatment space comprising the gas mixture at an average speed of at least 1 m/min while applying an electrical potential across the electrodes, thereby generating a glow discharge plasma in the treatment space and depositing an inorganic layer on one or both sides of the two substrates at the same time. This has time and economic advantages and makes better use of the gas mixture, treatment space and apparatus. As illustrated in Fig. 5, the electrodes 4a, 4b can be provided with a dielectric barrier layer 4d1, 4d2 (see the detailed schematic view as shown in Fig. 5). The dielectric layer 4d1 on the first electrode 4a has a thickness of d1 (mm), and the dielectric layer 4d2 on the second electrode 4b has a thickness of d2 (mm). In operation, the total dielectric distance d of the electrode configuration also includes the thickness of the (one or two) substrates 5, 5b (or 1a, 1b) to be treated, indicated by f1 (mm) and f2 (mm) in Fig. 5. Thus, the total dielectric thickness d of the dielectric barrier in the treatment space 8 between the at least two opposing electrodes (4a, 4b) in Fig. 5 is d = d1+f1+f2+d2.

In a further embodiment, both d1 and d2 are 0 and the only dielectric material forming the dielectric barrier is the substrate 1. When two substrates (1a, 1b or 5a, 5b) are moved in step c), the total dielectric thickness d in this case is d= f1 + f2, as illustrated in Fig. 5.

In still another embodiment both d1 and d2 are 0 and only one substrate 1 is used. In this embodiment the total dielectric thickness equals f1, so d = f1. Also in this embodiment in which electrode 4a is not covered with a dielectric material it is possible to obtain a stable atmospheric glow discharge plasma.

The gap distance g indicates the smallest gap between the electrodes 4a, 4b where an atmospheric pressure glow discharge plasma can exist in operation (i.e. in the treatment space 8), also called the free inter-electrode space. The dimensions of the electrodes 4a, 4b, dielectric barrier layers 4d1, 4d2, and gap g between the electrodes 4a, 4b, are predetermined in order to generate and sustain a glow discharge plasma at about atmospheric pressure in the treatment space 8.

The dimensions of the electrodes 4a, 4b, dielectric barrier layers 4d1, 4d2, and gap g between the electrodes 4a, 4b and the total dielectric distance (d) which is the total dielectric thickness of the dielectric barrier are controlled in a further embodiment, such that the product of gap distance and the total dielectric distance is arranged to be less than or equal to 1.0 mm² or even more preferred less than 0.5 mm². This is described in more detail in European patent applications EP2245647 and EP2528082 of same applicant.

The organic, polymeric substrate 1 has a thickness smaller than the gap distance g between the at least two opposing electrodes 4a, 4b. Preferably the substrate has a thickness of 20µm to 800 µm, more preferably 40 to 300 µm, for example 50µm or 100 µm or 200 µm. When the method is performed on two substrates 1a, 1b (or 5a, 5b) simultaneously, the total thickness of the two substrates is selected to be less than the gap distance g between the at least two opposing electrodes 4a,4b.

Preferably the substrate and/or the transparent sheet material are sufficiently flexible for them to be wound on and off a spool having a diameter of 1cm and/or 1m as this facilitates automation of the method.

By this method and apparatus, an inorganic layer can be deposited on substrates having a relatively low Tg, meaning that PEN and PET can be used as the substrate and be provided with inorganic layers on each side. The substrate is optionally reinforced, e.g. using glass fibre, to improve impact resistance of the resultant transparent sheet material.

Thus the present method can be used to provide transparent sheet materials comprising at least three layers: an inorganic layer, an organic polymeric substrate and an inorganic layer, in that order.

The formation of the glow discharge plasma may be stimulated by controlling the displacement current (dynamic matching) using the plasma control unit 9 (see Fig. 4) connected to the electrodes 4a, 4b, leading to a uniform activation of the surface of substrate in the treatment space 8 whereby the discharge energy supplied to the substrate is controlled to below 25 J/cm². The plasma control unit 9 comprises, for example, a power supply 7 and associated control circuitry (e.g. stabilization circuit 21), as described in EP-1917842, EP-1381257 and EP-1626613.

Preferably the power supply 7 is capable of providing a wide range of frequencies. For example, one may use a power supply 7 which can provide (i) a low frequency electrical signal (e.g. 10-450 kHz); and/or (ii) a high frequency electrical signal (e.g. 450kHz - 30MHz). Other suitable frequency ranges include 450kHz- 1 MHz and/or 1 to 20MHz, and the like.

The on-time may vary from very short times (e.g. 20 microseconds), to short times (e.g. 500 microseconds) to longer times (e.g. 2 minutes or continuously). The on-time effectively results in a pulse train having a series of sine wave periods at the operating frequency, with a total duration of the on-time.

The method is preferably performed using a duty cycle of at least 90 % and, in the most preferred embodiment, no off-time at all (i.e. duty cycle of 100%).

In one embodiment the substrate is heated during step c), e.g. to a temperature in the range 60 to 100°C, more preferably 65 to 95°C and especially 70 to 90°C. By heating the substrate I this way, e.g. by using an electrode 4a, 4b which comprises a heating element, it was surprisingly found that dust formation was reduced, or even eliminated, while still obtaining good inorganic layer deposition on the substrate 1. In order to raise the temperature during step c) various other embodiments may be used. Examples of such embodiments using temperature control units 16 and elements 15 and 17, for example as described in WO2008147184, Fig. 6.

The gas mixture optionally comprises an inert gas.

Preferably the method further comprises the step of preparing the gas mixture in a buffer chamber.

The gas mixture provided in step b) preferably comprises a total amount of reactive gas(es) of 5 to 25 vol%, more preferably 10 to 23 vol% and especially 15 to 21 vol%.

Preferred reactive gases include oxygen, hydrogen, carbon dioxide, nitrogen oxide and combinations comprising two or more thereof.

The gas mixture provided in step b) preferably comprises a total amount of inert gas(es) of 75 to 96 vol%, more preferably 77 to 90 vol% and especially 78 to 85 vol%. Preferred inert gases include, for example, argon, helium, nitrogen or combination of two or all three thereof.

The gas mixture provided in step b) preferably comprises a total amount of precursor(s) of at least from 100 ppm, more preferably 150 to 800 ppm and especially 200 to 700 ppm.

The purpose of the precursor is to decompose in the treatment space 5 on contact with the plasma to form an inorganic material comprising silicon which is then deposited on the substrate 1a, 1b or 5a, 5b as inorganic layer 2a or 2b. Thus the precursor is a compound which is decomposable to an inorganic material comprising silicon on contact with plasma.

As examples of suitable precursors there may be mentioned hexamethyldisiloxane (HMDSO), tetramethyldisiloxane (TMDSO), 1,1,3,3,5a, 5b-hexamethyltrisiloxane, hexamethylcyclotetrasiloxane, octamethylcyclotetrasiloxane, decamethylcyclopentanesiloxane, tetraethoxysilane (TEOS), tetramethoxysilane (TMOS), methyltrimethoxysilane, methyltriethoxysilane, dimethyldimethoxysilane, dimethyldiethoxysilane, trimethylethoxysilane, ethyltrimethoxysilane, ethyltriethoxysilane, n-propyltrimethoxysilane, n-propyltriethoxysilane, n-butyltrimethoxysilane, i-butyltrimethoxysilane, n-hexyltrimethoxysilane, phenyltrimethoxysilane, vinyltrimethoxysilane, vinyltriethoxysilane, aminomethyltrimethylsilane, dimethyldimethylaminosilane, dimethylaminotrimethylsilane, allylaminotrimethylsilane, diethylaminodimethylsilane, 1-trimethylsilylpyrrole, 1-trimethylsilylpyrrolidine, isopropylaminomethyltrimethylsilane, diethylaminotrimethylsilane, anilinotrimethylsilane, 2-piperidinoethyltrimethylsilane, 3-butylaminopropyltrimethylsilane, 3-piperidinopropyltrimethylsilane, bis(dimethylamino)methylsilane, 1-trimethylsilylimidazole, bis(ethylamino)dimethylsilane, bis(butylamino)dimethylsilane, 2-aminoethylaminomethyldimethylphenylsilane, 3-(4-methylpiperazinopropyl)trimethylsilane, dimethylphenylpiperazinomethylsilane, butyldimethyl-3-piperazinopropylsilane, dianilinodimethylsilane, bis(dimethylamino)diphenylsilane, 1,1,3,3-tetramethyldisilazane, 1,3-bis(chloromethyl)-1,1,3,3-tetramethyldisilazane, hexamethyldisilazane (HMDSN), 1,3-divinyl-1,1,3,3-tetramethyldisilazane and mixtures comprising two or more thereof.

Thus the inorganic layer comprises silicon, for example the degradation product of any of the foregoing precursors.

Preferably the electrodes apply a discharge energy to the substrate of from 0.25 to 24 J/cm², especially 0.5 to 23 J/cm², more especially 0.75 to 22 J/cm² and particularly 1 to 20 J/cm². In one embodiment the electrodes apply a discharge energy to the substrate of from 0.75 to 15 24 J/cm².

The applied discharge energy may be calculated as illustrated in the following example calculation: if the power supply provides 600 Watts power and the substrate present in the treatment space has the dimensions 2cm x 15cm then this equates to a discharge energy of 600W/30cm² = 20J/cm²*s (wherein s is the length of time the plasma is in contact with the relevant area of the substrate in seconds, which in turn depends on the speed referred to in step c)).

Preferably the gap (g) (or distance) between the at least two opposing electrodes (e.g. anode and cathode) is from 0.1 to 2 mm, more preferably from 0.2 to 1.5 mm and especially from 0.3 to 1 mm.

The speed referred to in step c) may be varied while applying the electrical potential across the electrodes. However it is preferred to keep the speed substantially constant while applying the electrical potential across the electrodes, e.g. to within 10%, more preferably to within 5% of the average speed while applying the electrical potential across the electrodes.

In step c) the substrate is preferably moved through the treatment space comprising the gas mixture at an average speed of 1 to 100 m/min (preferably with the electrodes applying a discharge energy to the substrate of 0.5 to 23 J/cm²), more preferably 1.5 to 50 m/min (preferably with the electrodes applying a discharge energy to the substrate of 1 to 20 J/cm²).

The speed referred to in step c) of the present method is much greater than is typically used for preparing water vapour barriers where speeds of about 0.1 m/min are typically used. The present method enables one to prepare transparent sheet materials comprising an organic, polymeric substrate having very thin inorganic layers on each side, e.g. inorganic layers of average thickness less than 30 nm, more preferably less than 15 nm, especially less than 10 nm and more especially less than 5 nm. The term "overall thickness" has no particular meaning beyond the word "thickness" and may freely be replaced by such word. What matters is that the average thickness of the inorganic layer on each side of the substrate is less than 5 nm.

Preferably the inorganic layers on each side of the substrate are applied to the substrate sequentially, on one side and then on the other side, e.g. in the same treatment space or in different treatment spaces. In contrast to the sheet materials made by many prior methods, the present method can be used to provide transparent sheet materials having very thin inorganic layers on each side of the substrate which are less brittle and less prone to cracking upon bending.

The glow discharge plasma generated in step c) preferably has a width of 5 to 300 cm, especially 6 to 100 cm, more preferably 7 to 50 cm.

The glow discharge plasma generated in step c) preferably has a length when measured in the direction of gas flow through the treatment space of from 0.5 to 10 cm, especially 0.5 to 5 cm.

The method of the present invention preferably comprises PECVD.

According to a second aspect of the present invention there is provided a transparent sheet material obtainable or obtained by a method according to the first aspect of the present invention. The preferences for the transparent sheet material are as hereinbefore described in relation to the first aspect of the present invention.

The present invention may be used to provide a flexible, transparent sheet material comprising an organic, polymeric substrate and an inorganic layer on each side of the substrate, wherein (i) the organic, polymeric substrate is polyethylene terephthalate or polyethylene naphthalate; (ii) the overall thickness of the inorganic layer(s) on each side of the substrate is less than 5 nm; and (iii) the inorganic layer on each side of the substrate comprises silicon. The preferences for the transparent sheet material are as hereinbefore described in relation to the first aspect of the present invention. Preferably the inorganic layers have been applied to each side of the substrate by a method comprising plasma-enhanced chemical vapour deposition.

The present invention may be used to reduce the susceptibility of an organic, polymeric substrate to heat-induced haze formation comprising applying inorganic layers to each side of the substrate wherein the overall thickness of the inorganic layer(s) on each side of the substrate is less than 5nm. The preferences for this aspect are as hereinbefore described in relation to the first aspect of the present invention.The inorganic layers are preferably applied to each side of the substrate by a method comprising plasma-enhanced chemical vapour deposition.

Thus the present invention may use plasma-enhanced chemical vapour deposition to reduce the susceptibility of an organic, polymeric substrate to heat-induced haze formation. The preferences for this are as hereinbefore described in relation to the first aspect of the present invention.

The present invention may therefore be used to provide a transparent sheet material which reduces in transparency by less than 5% when heated for 30 minutes at 150°C, as measured using light of wavelength 589nm.

The following abbreviations are used in the Examples:
PET I means optical grade polyethylene terephthalate of thickness 100 µm and width 17.8 cm (Cosmoshine™ from Toyobo).
PET II means optical grade polyethylene terephthalate of thickness 125 µm and width 17.8 cm (Melinex™ ST504 from DuPont Teijin Films).
PEN means optical grade, thermally stabilized polyethylene-2,6-naphthalate of thickness 100 µm and width 17.8 cm (TEONEX™ Q65FA from Dupont Teijin Films).

### Examples 1 to 16 and Comparative Examples CEx1 to CEx9

Flexible, transparent sheets were prepared by the method of the present invention using the apparatus shown schematically in Fig 3, comprising two rotatable roll-electrodes, each having a radius of 120 mm, using the conditions indicated in Table 1.

To enable precise temperature control, each rotatable roll-electrode was equipped with a spiral tube affixed to the inner surface of the electrode. Heated liquid (oil) was pumped through the spiral tube to control the temperature of the electrode surface to 80°C ± 1°C. The substrates served two purposes: firstly, to act as the dielectric layer for diffuse dielectric barrier discharge (DBD), and secondly to be the support for the flexible sheet for deposition. The apparatus comprised two roll-to-roll transport and tension control systems for delivering the substrates to the electrodes and then for collecting the resultant flexible, transparent sheet. The substrates were transported through the treatment space between the electrodes at the speeds indicated in Table 1 below.

As indicated in Fig. 1, a gas mixture comprising inert gases (e.g. nitrogen and argon), a reactive gas (e.g. oxygen) and precursor (e.g. HMDSO, TMOS, TMDSO, HMDSN or TEOS) were fed into the treatment space between the electrodes. The ratio of each of these gas mixture components and the flow rate of the gas mixture in standard litres per minute ("slm") are shown in Table 1. Before the gas mixture was fed into the treatment space, it was first prepared in a buffer chamber. Due to its high vapor pressure at room temperature, the precursor was injected into the buffer chamber via a controlled evaporation mixer unit (Bronkhorst) along with nitrogen, argon and oxygen, each at the rate shown in Table 1. The amount of precursor injected into the buffer chamber is indicated in Table 1 in ppm. The resultant gas mixtures were then fed from the buffer chamber into the treatment space between the electrodes at the flow rate indicated in Table 1.

The gap (g) between the electrodes was 0.5 mm. The plasma discharges created by each electrode had a width of approximately 15 cm and a length of about 2 cm (the length being measured in the direction of gas flow through the treatment space). However, the exact dimensions of plasma discharges depended to some extent on the applied power, the composition of the gas mixture and the gas flow rate.

The plasma discharges were created using a high frequency generator from Seren Industrial Power Systems (L3001). The cylindrical electrodes were connected to an external AC circuit via carbon brush-type electrical contacts and the operational frequency was 150 kHz. The apparatus was operated in the pulsed mode with a high voltage (4-5 kV (peak-peak) pulse duration of 800 µs and 90% duty cycle). The power dissipated in the plasma discharges was 600 W. The discharge current and the voltage were measured by a Pearson current monitor 4100 and a Tektronix P6015A probe respectively.

In the Examples of the invention the substrates were treated twice as described above, once on each side of the substrate, so that a layer of inorganic material was deposited on both sides of the substrate. In CEx 7, CEx8 and CEx9 the layer of inorganic material was deposited on only one side of the substrate.

### Test Results

### 1) Transparency of Resultant Flexible. Transparent Sheet (%)

The transparency of the resultant flexible, transparent sheets at 589nm was measured before and after heating the sheets for 30 minutes at 150°C. The % figure provided in table 1 is the % transmission after the abovementioned heating relative to the transmission before heating. Transmission was measured using a UV/VIS spectrometer at perpendicular light incidence.

### 2) Average Thickness of the Deposited Inorganic Layer

The thickness of the deposited inorganic layers was determined using a variable angle spectroscopic ellipsometer (M-2000D, J.A. Woollam Inc.) operated in the wavelength range of 400-1000 nm.

### 3) Cracking on Bending after Winding

The resultant flexible, transparent sheet materials were bent and then visually inspected using a microscope at x100 magnification. The presence or absence of cracking of the inorganic layer was then noted.

**Table 1**

| Method Conditions | | | | | | | Results | | |
|---|---|---|---|---|---|---|---|---|---|
| | Substrate & No. sides carrying inorganic layer deposit | Ratio N₂/O₂/Ar in slm entering the buffer chamber | C (concentration of precursor in gas mixture in ppm by volume) | Precursor | S (speed of substrate through treatment space in metres per minute) | Discharge energy density (J/cm² of substrate) | Transmission of resultant flexible, transparent sheet (%) | Average Thickness of deposited inorganic layer on each side (../..) in nm | Cracking on bending after winding |
| CEx1 | PET I (none) | NA | NA | NA | NA | NA | 85 | NA | NA |
| CEx2 | PET II(none) | NA | NA | NA | NA | NA | 85 | NA | NA |
| CEx3 | PEN (none) | NA | NA | NA | NA | NA | 85 | NA | NA |
| CEx4 | PET I(both) | 15/1/1 | 95 | TEOS | 0.1 | 240 | 98 | 48/51 | Yes |
| CEx5 | PEN (both) | 15/1/1 | 95 | TEOS | 0.1 | 240 | 98 | 50/51 | Yes |
| CEx6 | PEN (both) | 15/1/1 | 68 | HMDSO | 0.1 | 240 | 98 | 50/49 | Yes |
| Ex1 | PET I(both) | 15/1.8/1 | 554 | TEOS | 16 | 1.5 | 98 | 3/2 | No |
| Ex2 | PET I(both) | 15/1.8/1 | 554 | TEOS | 8 | 3 | 98 | 4/4 | No |
| Ex3 | PET I(both) | 15/1.8/1 | 554 | TEOS | 4 | 6 | 98 | 9/11 | No |
| Ex4 | PET I(both) | 15/1.8/1 | 554 | TEOS | 2 | 12 | 98 | 21/18 | No |
| Ex5 | PEN (both) | 15/1.8/1 | 554 | TEOS | 16 | 1.5 | 98 | 2/4 | No |
| Ex6 | PENI(both) | 15/1.8/1 | 554 | TEOS | 8 | 3 | 98 | 4/4 | No |
| Ex7 | PEN (both) | 15/1.8/1 | 554 | TEOS | 4 | 6 | 98 | 11/9 | No |
| Ex8 | PEN (both) | 15/1.8/1 | 554 | TEOS | 2 | 12 | 98 | 21/23 | No |
| Ex9 | PEN (both) | 15/1.8/1 | 554 | TEOS | 2 | 12 | 98 | 21/23 | No |
| Ex10 | PET I (both) | 15/1.8/1 | 350 | HMDSO | 16 | 1.5 | 98 | 3/2 | No |
| Ex11 | PET II (both) | 15/1.8/1 | 350 | HMDSO | 16 | 1.5 | 98 | 3/4 | No |
| Ex12 | PET I (both) | 15/1.8/1 | 340 | HMDSN | 16 | 1.5 | 98 | 3/2 | No |
| Ex13 | PET I (both) | 15/1.8/1 | 554 | TMOS | 16 | 1.5 | 98 | 3/2 | No |
| Ex14 | PET II (both) | 15/1.8/1 | 340 | HMDSN | 16 | 1.5 | 98 | 3/2 | No |
| Ex15 | PET I (both) | 15/1.8/1 | 550 | TMDSO | 16 | 1.5 | 98 | 2/2 | No |
| Ex16 | PET II (both) | 15/1.8/1 | 550 | TMDSO | 16 | 1.5 | 98 | 2/2 | No |
| CEx7 | PET I(one) | 15/1.8/1 | 554 | TEOS | 16 | 1.5 | 92 | 2/-- | No |
| CEx8 | PET II(one) | 15/1.8/1 | 554 | TEOS | 16 | 1.5 | 92 | 2/-- | No |
| CEx9 | PEN (one) | 15/1.8/1 | 554 | TEOS | 16 | 1.5 | 92 | 2/-- | No |

| | | | | | | | | | |
|---|---|---|---|---|---|---|---|---|---|
| NA means not applicable | | | | | | | | | |

## Claims

1. A method for preparing a transparent sheet material comprising an organic, polymeric substrate and an inorganic layer on each side of the substrate, the method comprising the steps of:
a) providing an apparatus for generating a glow discharge plasma, said apparatus comprising at least two opposing electrodes, a power supply for the electrodes and a treatment space between the electrodes;
b) providing the treatment space with a gas mixture at about atmospheric pressure, the gas mixture comprising a reactive gas and a precursor; and
c) moving a transparent substrate through the treatment space comprising the gas mixture at an average speed of at least 1 m/min while applying an electrical potential across the electrodes, thereby generating a glow discharge plasma in the treatment space and depositing an inorganic layer on one or both sides of the substrate;
wherein:
(i) the organic, polymeric substrate is polyethylene terephthalate or polyethylene naphthalate;
(ii) the electrodes apply a discharge energy to the substrate of less than 25 J/cm2;
(iii) the overall thickness of the inorganic layer on each side of the substrate is less than 5 nm and
(iv) the inorganic layer on each side of the substrate comprises silicon.

2. A method according to claim 1 wherein step c) further comprises heating the substrate in the treatment space.

3. A method according to any one of the preceding claims wherein the inorganic layer on each side of the substrate are applied to the substrate sequentially.

4. A method according to any one of the preceding claims wherein the substrate and the transparent sheet material are sufficiently flexible for them to be wound on and off a spool having a diameter of 1 cm.

5. A method according to any one of the preceding claims in which the power supply provides a duty cycle of at least 90%.

6. A method according to any one of the preceding claims wherein the gas mixture further comprises an inert gas.

7. A method according to any one of the preceding claims wherein the total amount of reactive gas(es) present in the gas mixture is 5 to 25 vol%.

8. A method according to any one of the preceding claims wherein the total amount of precursor(s) present in the gas mixture is at least 100 ppm.

9. A method according to any one of the preceding claims wherein the total amount of inert gas(es) present in the gas mixture is 75 to 96 vol%.

10. A flexible, transparent sheet material comprising an organic, polymeric substrate and an inorganic layer on each side of the substrate, wherein (i) the organic, polymeric substrate is polyethylene terephthalate or polyethylene naphthalate; (ii) the overall thickness of the inorganic layer(s) on each side of the substrate is less than 5 nm and (iii) the inorganic layer on each side of the substrate comprises silicon.

## Patentansprüche

1. Verfahren zur Herstellung eines transparenten Bogenmaterials, umfassend ein organisches polymeres Substrat und eine anorganische Schicht auf jeder Seite des Substrats, wobei das Verfahren die Schritte umfasst:
a) Bereitstellen einer Vorrichtung zum Generieren eines Glimmentladungsplasmas, wobei die Vorrichtung mindestens zwei gegenüber befindliche Elektroden, eine Leistungsversorgung für die Elektroden und einen Behandlungsraum zwischen den Elektroden umfasst;
b) Bereitstellen einer Gasmischung mit etwa atmosphärischem Druck in dem Behandlungsraum, wobei die Gasmischung ein reaktives Gas und einen Vorläufer umfasst; und
c) Bewegen eines transparenten Substrats durch den Behandlungsraum, der die Gasmischung umfasst, mit einer durchschnittlichen Geschwindigkeit von mindestens 1 m/min, während ein elektrisches Potential über die Elektroden angelegt wird, wodurch ein Glimmentladungsplasma in dem Behandlungsraum generiert wird und eine anorganische Schicht auf einer oder beiden Seiten des Substrats abgeschieden wird;
wobei:
(i) das organische polymere Substrat Polyethylenterephthalat oder Polyethylennaphthalat ist;
(ii) die Elektroden an das Substrat eine Entladungsenergie von weniger als 25 J/cm² anlegen;
(iii) die Gesamtdicke der anorganischen Schicht auf jeder Seite des Substrats weniger als 5 nm beträgt, und
(iv) die anorganische Schicht auf jeder Seite des Substrats Silicium umfasst.

2. Verfahren nach Anspruch 1, wobei Schritt c) ferner Erwärmen des Substrats in dem Behandlungsraum umfasst.

3. Verfahren nach einem der vorhergehenden Ansprüche, wobei die anorganische Schicht auf jeder Seite des Substrats nacheinander auf das Substrat aufgebracht wird.

4. Verfahren nach einem der vorhergehenden Ansprüche, wobei das Substrat und das transparente Bogenmaterial ausreichend flexibel sind, damit sie auf eine Spule mit einem Durchmesser von 1 cm aufgewickelt und von dieser abgewickelt werden können.

5. Verfahren nach einem der vorhergehenden Ansprüche, wobei die Leistungsversorgung eine Arbeitsphase von mindestens 90 % bereitstellt.

6. Verfahren nach einem der vorhergehenden Ansprüche, wobei die Gasmischung ferner ein Inertgas umfasst.

7. Verfahren nach einem der vorhergehenden Ansprüche, wobei die Gesamtmenge des reaktiven Gases bzw. der reaktiven Gase, das/die in der Gasmischung vorhanden ist/sind, 5 bis 25 Vol.% beträgt.

8. Verfahren nach einem der vorhergehenden Ansprüche, wobei die Gesamtmenge des Vorläufers bzw. der Vorläufer, der/die in der Gasmischung vorhanden ist/sind, mindestens 100 ppm beträgt.

9. Verfahren nach einem der vorhergehenden Ansprüche, wobei die Gesamtmenge des inerten Gases bzw. der inerten Gase, das/die in der Gasmischung vorhanden ist/sind, 75 bis 96 Vol.% beträgt.

10. Flexibles transparentes Bogenmaterial, das ein organisches polymeres Substrat und eine anorganische Schicht auf jeder Seite des Substrats umfasst, wobei (i) das organische polymere Substrat Polyethylenterephthalat oder Polyethylennaphthalat ist; (ii) die Gesamtdicke der anorganischen Schicht (en) auf jeder Seite des Substrats kleiner als 5 nm ist, und (iii) die anorganische Schicht auf jeder Seite des Substrats Silicium umfasst.

## Revendications

1. Procédé pour la préparation d'un matériau en feuille transparente comprenant un substrat polymère organique et une couche inorganique sur chaque face du substrat, le procédé comprenant les étapes de :
a) mise à disposition d'un appareil pour la génération d'un plasma à décharge luminescente, ledit appareil comprenant au moins deux électrodes opposées, une alimentation électrique pour les électrodes et un espace de traitement entre les électrodes ;
b) apport à l'espace de traitement d'un mélange de gaz pratiquement à la pression atmosphérique, le mélange de gaz comprenant un gaz réactif et un précurseur ; et
c) déplacement du substrat transparent à travers l'espace de traitement comprenant le mélange de gaz à une vitesse moyenne d'au moins 1 m/min tout en appliquant un potentiel électrique à travers les électrodes, générant ainsi un plasma à décharge luminescente dans l'espace de traitement et déposant ainsi une couche inorganique sur l'une des deux faces du substrat ;
(i) le substrat polymère organique étant le poly(téréphtalate d'éthylène) ou le poly(naphtalate d'éthylène) ;
(ii) les électrodes appliquant une énergie de décharge au substrat inférieure à 25 J/cm²
(iii) l'épaisseur globale de la couche inorganique sur chaque face du substrat étant inférieure à 5 nm et
(iv) la couche inorganique sur chaque face du substrat comprenant du silicium.

2. Procédé selon la revendication 1, l'étape c) comprenant en outre le chauffage du substrat dans l'espace de traitement.

3. Procédé selon l'une quelconque des revendications précédentes, la couche inorganique sur chaque face du substrat étant appliquée au substrat de manière séquentielle.

4. Procédé selon l'une quelconque des revendications précédentes, le substrat et le matériau en feuille transparente étant suffisamment flexibles pour être enroulés sur une bobine ou déroulés d'une bobine possédant un diamètre de 1 cm.

5. Procédé selon l'une quelconque des revendications précédentes, l'alimentation électrique délivrant un facteur d'utilisation d'au moins 90%.

6. Procédé selon l'une quelconque des revendications précédentes, le mélange de gaz comprenant en outre un gaz inerte.

7. Procédé selon l'une quelconque des revendications précédentes, la quantité totale de gaz réactif(s) présent(s) dans le mélange de gaz étant de 5 jusqu'à 25% en volume.

8. Procédé selon l'une quelconque des revendications précédentes, la quantité totale de précurseur(s) présent(s) dans le mélange de gaz étant d'au moins 100 ppm.

9. Procédé selon l'une quelconque des revendications précédentes, la quantité totale de gaz inerte(s) présent (s) dans le mélange de gaz étant de 75 jusqu'à 96% en volume.

10. Matériau en feuille transparente, flexible, comprenant un substrat polymère organique et une couche inorganique sur chaque face du substrat, (i) le substrat polymère organique étant le poly(téréphtalate d'éthylène) ou le poly(naphtalate d'éthylène) ; (ii) l'épaisseur globale de la/des couche(s) inorganique(s) sur chaque face du substrat étant inférieure à 5 nm et (iii) la couche inorganique sur chaque face du substrat comprenant du silicium.
